# EUROPEAN PATENT SPECIFICATION

(11) **EP 0 746 032 B1**
(45) Date of publication and mention of the grant of the patent: **17.10.2001**
(21) Application number: 95119739.1
(22) Date of filing: 14.12.1995
(51) Int. Cl.: H01L 27/06, H01L 21/8249

(54) **Semiconductor integrated circuit comprising bipolar transistors and MOS transistors and associated fabrication method**
Integrierte Halbleiterschaltung bestehend aus bipolaren Transistoren und MOS Transistoren und dazugehöriges Herstellungsverfahren
Circuit intégré semi-conducteur comprenant des transistors bipolaires et des transistors MOS et sa méthode de fabrication

(30) Priority: 29.05.1995 JP 13047295
(43) Date of publication of application: 04.12.1996
(73) Proprietor: MATSUSHITA ELECTRIC INDUSTRIAL CO., LTD., Kadoma-shi, Osaka (JP)
(72) Inventor: Sawada, Shigeki, Kyoto 619-02 (JP); Furuta, Takashi, Moriyama-shi, Shiga 524 (JP)
(74) Representative: Grünecker, Kinkeldey, Stockmair & Schwanhäusser Anwaltssozietät

(56) References cited:
- EP-A- 0 435 257
- PATENT ABSTRACTS OF JAPAN vol. 013, no. 110 (E-728), 16 March 1989 & JP 63 281456 A (HITACHI LTD), 17 November 1988,

## Description

### BACKGROUND OF THE INVENTION

This invention relates to a semiconductor integrated circuit (SIC) apparatus formed of self-aligned, high-speed bipolar transistors, and CMOS transistors inseparably associated on a single body of semiconductor material, and to an associated fabrication method.

In recent years, mobile communication tools such as mobile telephones have made remarkable advances, and techniques capable of integration of high-frequency circuits and high-integration logic circuits in a single SIC are required. In other words, a technique is required which is capable of inextricably binding self-aligned, high-speed bipolar transistors suitable for, for example, high-speed ECL (emitter-coupled logic) circuits, and high-integration, low-power CMOS logic circuits, on a single semiconductor substrate.

There are various self-alignment techniques. For example, Japanese Patent Application, published under Pub. No. 63-281456, shows a self-alignment technique. In accordance with this technique, a transistor with a self-aligned base extraction electrode and a self-aligned emitter extraction portion and a CMOS transistor are placed on a single semiconductor substrate.

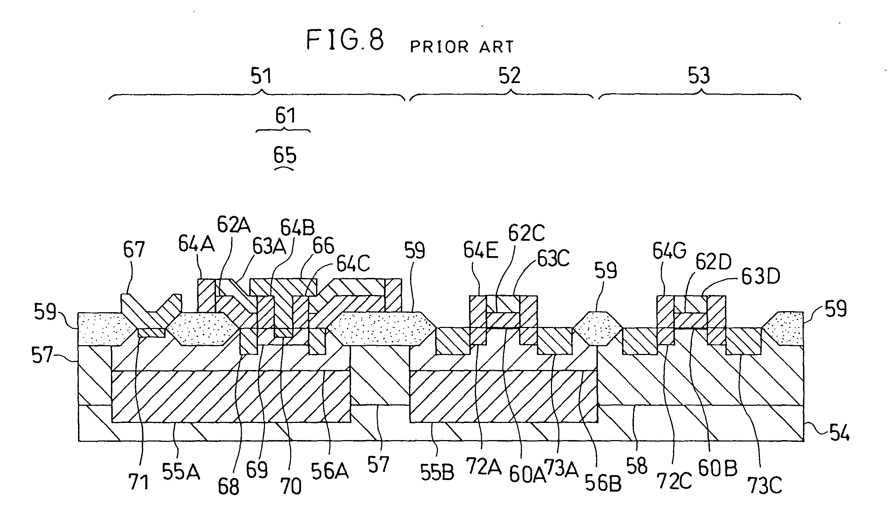

FIGURE **8** is a cross section of an SIC apparatus made in accordance in a conventional self-alignment technique. **54** is a p-type semiconductor substrate of silicon. Formed on the silicon substrate **54** are three transistors of different types, i.e., an npn bipolar transistor **51,** a p-channel MOS (PMOS) transistor **52,** and an n-channel MOS (NMOS) transistor **53. 57** is a first well region of p-type which is formed as follows. An epitaxial layer of an n-type semiconductor material is deposited all over the substrate **54.** Subsequently, a region for isolation between devices of the epitaxial layer is subjected to an ion implant step and to a thermal annealing step, whereupon the p-well region **57** is formed such that it extends down to the silicon substrate **54. 59** is a LOCOS (local oxidation of silicon) layer for isolation between devices. The npn bipolar transistor **51,** the PMOS transistor **52,** and the NMOS transistor **53** are described in detail by making reference to FIG. **8.**

The structure of the bipolar transistor **51** is now explained. **55A** is an n-type buried collector region that is formed in the substrate **54** by means of ion implant and thermal annealing. **56A** is an n-type collector region formed by subjecting the n-type epitaxial layer deposited over the entirety of the substrate **54,** to an ion implant step and to a thermal annealing step. **61** is an emitter-base formation region formed in a self-aligned manner. **62A** is a base extraction electrode for the bipolar transistor **51** of polycrystalline silicon (polysilicon) that is p-doped. **63A** is an insulator layer of TEOS or the like material formed on top of the electrode **62A. 64A, 64B, 64C,** and **64D** are insulator side-wall layers for the electrode **62A** composed of TEOS or the like material. **65** is an emitter extraction opening that is formed in a manner of self-alignment with the side-walls layers **64B** and **64C. 66** is an emitter extraction electrode formed of polysilicon that is n-doped. **67** is a collector extraction electrode formed of polysilicon doped to n-type. **68** is a graft base region doped with impurities by a thermal annealing step through the electrode **62A. 69** is an active base region formed by a thermal annealing step. **70** is an emitter region formed, by a thermal annealing step performed through the electrode **66,** in a manner of self-alignment with the side-wall layers **64B** and **64C. 71** is a collector contact region formed by a thermal annealing step.

The structure of the PMOS transistor **52** is now explained. 55B is an n-type buried well region formed in the substrate **54** by an ion implant step. **56B** is an n-type well region formed in the epitaxial layer. **60A** is a first gate insulator layer formed by oxidation of a surface portion of the epitaxial layer. **62C** is a first gate electrode formed of polysilicon doped to n-type. **63C** is an insulator layer of TEOS or the like material formed on top of the electrode **62C. 64E** is an insulator side-wall layer of TEOS or the like material for the electrode **62C. 72A** is a first LDD (lightly doped drain) region that is formed in a manner of self-alignment with a side-surface of the electrode **62C. 73A** is a first source-drain region that is formed in a manner of self-alignment with the side-wall layer **64E** by means of an ion implant step.

The structure of the NMOS transistor **53** is now explained. **58** is a second p-type well region formed in the epitaxial layer in such a way as to extend to the substrate **54. 60B** is a second gate insulator layer formed by oxidation of a surface portion of the epitaxial layer. **62D** is a second gate electrode formed of polysilicon doped to n-type. **63D** is an insulator layer of TEOS or the like material formed on top of the electrode **62D. 64G** is an insulator side-wall layer for the electrode **62D. 72C** is a second LDD region that is formed in a manner of self-alignment with a side-surface of the electrode **62D. 73C** is a second source-drain region that is formed in a manner of self-alignment with the side-wall layer **64G** by means of an ion implant step.

For example, in the PMOS transistor **52,** the side-surface of the electrode **62C** and the side-wall layer **64E** act as a side-wall in order that an LDD structure, which is capable of suppressing generation of hot carriers which causes deterioration in performance, is achieved.

In the bipolar transistor **51,** the side-wall layers **64B** and **64C** are formed and self-aligned in the same fabrication step as the side-wall layer **64E.** As a result of such arrangement, the dimensions of the emitter region **70** are reduced thereby reducing junction capacitance. The distance between the electrode **62A** and the emitter region **70** is made short to reduce base resistance. The high-frequency characteristics are improved.

The distance between the graft base region **68** and the emitter region **70** (hereinafter called the FIRST PARAMETER) is a key factor for both the value of base resistance and the carrier transit time affecting the way in which the bipolar transistor **51** operates. For example, the distance between the electrode **62C** and the source-drain region **73A** (hereinafter called the SECOND PARAMETER) is a key factor for both the resistance to hot carriers and the saturation drain current value affecting the way in which the PMOS transistor **52** operates.

The above-described SIC apparatus, however, has some disadvantages. For example, FIRST and SECOND PARAMETERS are determined by the thickness of the side-wall layer **64B** and the thickness of the side-wall layer **64E.** It is extremely difficult to determine both the thickness of the side-wall layer **64B** and the thickness of the side-wall layer **64E** in a single fabrication step for optimization of operating characteristics. Conventionally, in order to guarantee the performance of the PMOS transistor **52,** the side-wall layer **64E** which determines an LDD structure tends to be optimized in preference to the side-wall layer **64B.** Therefore, it is difficult to secure a sufficient fabrication processing margin.

Further, in the bipolar transistor 51, the thick side-wall layers **64B** and **64C** are formed around the perimeter of the emitter-base junction. As a result, when the side-wall layers **64B**, **64C**, the thermal capacity of which is great, cool down, resulting contraction stress is applied to the perimeter of the emitter-base junction. This causes a deterioration in emitter-base leakage characteristic. Additionally, when the emitter width becomes narrow because of the miniaturization, the aspect ratio of the opening **65** (the ratio of the opening's **65** height to its diameter) increases. This results in increase in the emitter resistance.

A semiconductor integrated circuit apparatus having the features of the preamble of claim 1 is known from EP-A-0435257.

### SUMMARY OF THE INVENTION

Bearing in mind above-noted problems with the prior art technique, the present invention was made. Therefore, an object of this invention is to provide an improved SIC apparatus and method for fabricating the same.

The above object regarding the apparatus is achieved with a semiconductor integrated circuit having the features of claim 1 and a method having the features of claim 6.

With the inventive apparatus, the operating characteristics of bipolar and MOS transistors are optimized individually, the leakage characteristic between emitter and base is improved, and the emitter resistance of the emitter extraction electrode is reduced.

In accordance with the inventive SIC apparatus, the first side-wall layer of the bipolar transistor, which has conventionally been formed of a thick insulator layer, is made up of the thin insulator layer and the conductor layer. As a result of such arrangement, the thermal capacity of the first side-wall layer is reduced and less contraction stress is applied to around the perimeter of the emitter-base junction. The diameter of the emitter extraction opening increases because the conductor layer of the first side-wall layer and the emitter extraction electrode become an integral part, and hence the aspect ratio of the opening decreases. The emitter resistance of the emitter extraction electrode is reduced.

Additionally, the first side-wall layer and the second side-wall layer are formed in different fabrication steps. Accordingly, the distance between the graft base region and the emitter region can be controlled independently of the distance between the gate electrode and the source-drain region and both the distances can be optimized separately.

Further, the first side-wall layer is made up of the thin insulator layer and the conductor layer. As a result of such arrangement, less contraction stress is applied by the insulator layer to around the perimeter of the emitter-base junction. Deterioration in characteristic such as the leakage between emitter and base can be avoided.

The second side-wall layer is formed by lamination of the fourth insulator layer formed on the side-surface of the gate electrode and a fifth insulator layer overlying the fourth insulator layer. As a result of such arrangement, the distance between the graft base region (or extrinsic base region) and the emitter region of the bipolar transistor can be controlled independently of the distance between the gate electrode and the source-drain region of the MOS transistor, with greater latitude.

As the third insulator layer, which is formed together with the fourth insulator layer in a single fabrication step, becomes thin, the conductor layer becomes thick. As a result, deterioration in characteristic such as the leakage between emitter and base can be further improved and emitter resistance is further reduced.

It is preferable that in the above-described SIC apparatus the fifth insulator layer is a layer of silicon oxide. This ensures that the fifth insulator layer is obtained.

It is preferable that in the above-described SIC apparatus the second side-wall layer is additionally formed at a different side-surface of the base electrode facing in such a direction that the base extraction electrode extends over a layer for isolation between devices which surrounds the graft base region. As a result of such arrangement, deterioration in characteristic (e.g., leakage between other conductor layers through the conductor layer, and increase in parasitic capacitance) can be prevented without increasing the number of fabrication steps.

It is preferable that in the above-described SIC apparatus the third insulator layer is formed by lamination of an oxide layer formed on the side-surface of the base extraction electrode and a silicon nitride layer overlying the oxide layer. As a result of such arrangement, it is ensured that the third insulator layer is obtained.

It is preferable that in the above-described SIC apparatus the conductor layer is a layer of polysilicon. As a result of such arrangement, it is ensured that the conductor layer is obtained.

The above object with respect to the method is achieved with a method of fabricating a semiconductor integrated circuit apparatus having the features of claim 6.

In accordance with the inventive method, the first side-wall layer of the bipolar transistor, which has conventionally been formed of a thick insulator layer, is made up of the thin insulator layer and the conductor layer. As a result of such arrangement, the thermal capacity of the first side-wall layer is reduced and less contraction stress is applied to around the perimeter of the emitter-base junction. Deterioration in characteristic such as the leakage between emitter and base can be avoided.

The diameter of the emitter extraction opening increases because the conductor layer of the first side-wall layer and the emitter extraction electrode become an integral part, and hence the aspect ratio of the opening decreases. The emitter resistance of the emitter extraction electrode is reduced.

Additionally, the first side-wall layer and the second side-wall layer are formed in different fabrication steps. Accordingly, the distance between the graft base region and the emitter region can be controlled independently of the distance between the gate electrode of and the source-drain region. The base resistance value and the carrier travelling time affecting the way in which bipolar transistors operate, and the resistance to hot carriers and the saturation drain current value affecting the way in which MOS transistors operate, are all optimized.

Further, the conductor layer of the first side-wall layer is formed at a side-surface facing in such a direction that the base extraction electrode extends over a layer for isolation between devices which surrounds the graft base region. As a result of such arrangement, deterioration in characteristic (e.g., leakage between other conductor layers through the conductor layer, and increase in parasitic capacitance) can be prevented without increasing the number of fabrication steps.

The above-described method further comprises, after the step (g), depositing a fourth insulator layer on the entirety of the semiconductor substrate, and subjecting the fourth insulator layer to an etching step to form on the side-surface of the gate electrode the second side-wall layer composed of the second insulator layer, the third insulator layer, and the fourth insulator layer.

The distance between graft base region and emitter region in a bipolar transistor can be adjusted independently of the distance between gate electrode and source-drain region, with greater latitude. As a result, FIRST and SECOND PARAMETERS can be further optimized.

Further, the third insulator layer can be made thin, as a result of which the first conductor layer becomes thick. Deterioration in characteristic such as the leakage between emitter and base can be reduced.

### BRIEF DESCRIPTION OF THE DRAWINGS

FIGURE **1** is a cross-section of an SIC apparatus in accordance with a first embodiment of the present invention.

FIGURES **2-7** depict cross-sections of the fabrication of an SIC apparatus in accordance with a second embodiment of the present invention.

FIGURE **8** is a cross section of an SIC apparatus in accordance with a prior art technique.

### DETAILED DESCRIPTION OF THE INVENTION

### EMBODIMENT 1

Referring now to the accompanying drawing figures, a first preferred embodiment of this invention is described below.

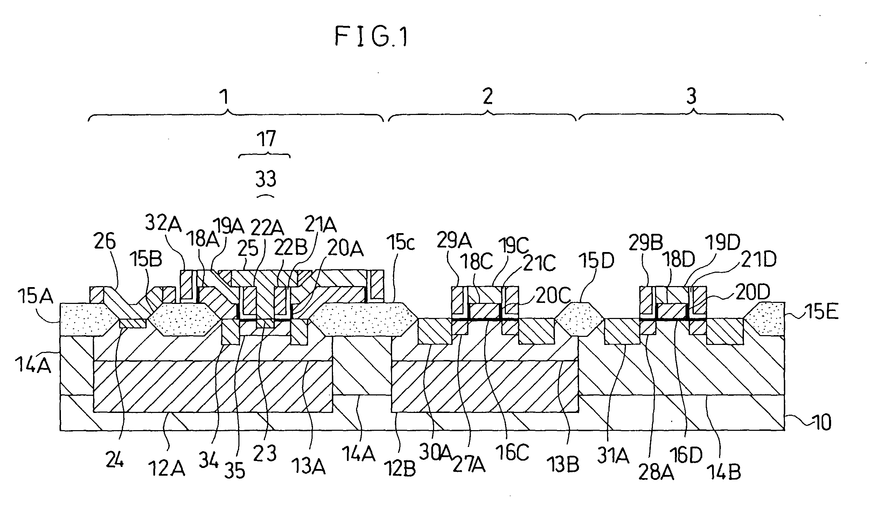

Referring first to FIG. **1,** there is shown the structure of an SIC apparatus made in accordance with the first embodiment. **10** is a p-type semiconductor substrate of silicon. **1** indicates an npn bipolar transistor formed on the silicon substrate **10. 2** indicates a p-channel MOS (PMOS) transistor formed on the silicon substrate **10. 3** indicates an n-channel MOS (NMOS) transistor formed on the silicon substrate **10. 14A** is a region for isolation between devices. The isolator region **14A** is formed as follows. A portion of an epitaxial layer of an n-type semiconductor material deposited on the entire surface of the silicon substrate **10,** is subjected to an ion implant step and a thermal annealing step, to form the isolator region **14A** in such a way that the isolator region **14A** extends down to the silicon substrate **10**. **14B** is a p-type well region. The p-well region **14B** is formed as follows. A portion of the n-epitaxial layer deposited on the silicon substrate **10** is subjected to an ion implant step and a thermal annealing step, to form the p-well region **14B** in such a way that the p-well region **14B** extends down to the silicon substrate **10. 15A-E** are LOCOS layers for isolation between devices. The npn bipolar transistor **1,** the PMOS transistor **2,** and the NMOS transistor **3** are described in detail.

The npn bipolar transistor **1** is first described with reference to FIG. **1. 12A** is an n-type buried collector region formed in the silicon substrate **10** by means of ion implant and thermal annealing. **13A** is an n-type collector region formed by subjecting a portion of the n-epitaxial layer deposited on the entirety of the silicon substrate **10** to an ion implant step and a thermal annealing step. **17** is an emitter-base formation region formed in a self-aligned manner. **18A** is a base extraction electrode for the npn bipolar transistor **1**. The electrode **18A** is composed of p-doped polysilicon. **19A** is an insulator layer formed on top of the electrode **18A.** The insulator layer **19A** is formed of TEOS or the like material. **20A** is an oxide layer formed at a side-surface of the electrode **18A** by means of thermal oxidation. **21A** is a silicon nitride layer deposited over the side-surface of the electrode **18A** by means of an LPCVD (low-pressure chemical vapor deposit) step and an etching step. **22A** and **22B** are polysilicon layers deposited by means of an LPCVD step and an etching step on the side-surfaces of the electrodes **18A, 18A,** respectively. **23** is an emitter region formed in a manner of self-alignment with the polysilicon layers **22A, 22B** by means of a thermal annealing step carried out through an emitter extraction electrode **25. 24** is a collector contact region formed by means of a thermal annealing step. The emitter extraction electrode **25** is composed of n-doped polysilicon. **26** is a collector extraction electrode composed of n-doped polysilicon. **32A** is an insulator side-wall layer for the electrode **18A** composed of TEOS or the like material. **33** is an emitter extraction opening formed in a manner of self-alignment with the layers **22A, 22B. 34** is a graft base region that is doped, through the electrode **18A,** with impurities by means of a thermal annealing step. **35** is an active base formed by means of a thermal annealing step.

The structure of the PMOS transistor **2** is now described. **12B** is an n-type buried well region formed in the silicon substrate **10** by means of an ion implant step. **13B** is an n-type well region formed by subjecting the n-epitaxial layer deposited on the silicon substrate **10** to an ion implant step and a thermal annealing step. **16C** is a first gate insulator layer formed by means of oxidation of a surface portion of the epitaxial layer. **18C** is a first gate electrode formed of n-doped polysilicon. **19C** is an insulator layer of TEOS or the like material overlying the electrode **18C. 20C** is an oxide layer formed at a side-surface of the electrode **18C** by means of thermal oxidation. **21C** is a silicon nitride layer formed at the side-surface of the electrode **18C** by means of LPCVD and etching. **27A** is a first LDD (lightly doped drain) region formed by having the silicon nitride layer **21C** serve as a side-wall. **29A** is an insulator side-wall layer for the electrode **18C** formed of TEOS or the like material. **30A** is a first source-drain region formed by means of ion implant in a manner of self-alignment with the side-wall layer **29A** serving as an ion implant side-wall.

The structure of the NMOS transistor **3** is now described. **14B** is a second p-type well region that is formed by subjecting the n-epitaxial layer to an ion implant step and a thermal annealing step of the epitaxial layer, so that the p-well region **14B** extends down to the silicon substrate **10. 16D** is a second gate insulator layer formed by oxidation of a surface portion of the epitaxial layer. **18D** is a second gate electrode formed of n-doped polysilicon. **19D** is an insulator layer of TEOS or the like material overlying the electrode **18D. 20D** is an oxide layer formed at a side-surface of the electrode **18D** by means of thermal oxidation. **21D** is a silicon nitride layer formed by means of LPCVD and etching at the side-surface of the electrode **18D. 28A** is a second LDD region formed by having the silicon nitride layer **21D** serve as a side-wall. **29B** is an insulator side-wall layer for the electrode **18D** formed of TEOS or the like material. **31A** is a second source-drain region that is formed by means of ion implant in a manner of self-alignment with the side-wall layer **29B** serving as an ion implant side-wall.

The silicon substrate **10** is a boron-doped, (100)-plane silicon the resistivity of which is about 10 Ω·cm. The npn bipolar transistor **1,** the PMOS transistor **2,** and the NMOS transistor **3** are formed on the silicon substrate **10**.

The buried collector region **12A** of the npn bipolar transistor 1 is formed by an impurity implant with arsenic or antimony. The junction depth and sheet resistivity of the collector region **12A** are 1-2 µm and 50-150 Ω/□ , respectively. The buried n-well region **12B** of the PMOS transistor **2** is likewise formed by an impurity implant with arsenic or antimony. The junction depth and sheet resistivity of the n-well region **12B** are 1-2 µm and 50-150 Ω/□ . The formation of the buried n-well region **12B** improves breakdown voltage between the drain-source region **3** of the npn bipolar transistor **1** and the silicon substrate **10.**

Impurities of arsenic or phosphorus are introduced onto the entire surface of the silicon substrate **10** to deposit the n-type epitaxial layer having a film thickness in the range of 0.8 to 1.5 *µ* m and a resistivity in the range of 1 to 5 Ω·cm. The film thickness of the epitaxial layer is defined by a region in the vertical direction of the n-collector region **13A** and the n-well region **13B.** The n-collector region **13A** is formed as follows. Phosphorus is introduced to form the collector region **13A** in the epitaxial layer such that the collector region **13A** extends to the n-collector region **12A** of the npn bipolar transistor **1**. The junction depth and surface concentration of the collector region **13A** are 0.8-1.5 *µ*m and about 5 × 10¹⁶cm⁻³, respectively. The collector region **13B** is formed as follows. Phosphorus is introduced to form the collector region **13B** in the epitaxial layer such that the collector region **13B** extends to the n-well region **12B** of the PMOS transistor **2.** The junction depth and surface concentration of the collector region **13B** are 0.8-1.5 *µ*m and about 5 × 10¹⁶cm⁻³, respectively.

The epitaxial layer thickness and the impurity concentration of both the n-collector region **12A** and the n-well region **13B** are key parameters which determine not only device breakdown voltage, carrier transit time, and the base junction capacitance of the npn bipolar transistor **1,** but also component performance such as device breakdown voltage and the source-drain junction capacitance of the PMOS transistor **2,** and they are optimized by the foregoing conditions.

The isolator region **14A** is formed as follows. Boron is introduced into the epitaxial layer to form the isolator region **14A** such that the isolator region **14A** extends to the silicon substrate **10** within a region for isolation between devices of the npn bipolar transistor **1.** The junction depth and surface concentration of the isolator region **14A** are 1.2-2.0 µm and about 7 × 10¹⁶cm⁻³, respectively. The p-well region **14B** is formed as follows. Boron is introduced into the epitaxial layer to form the p-well region **14B** such that the p-well region **14B** extends to the silicon substrate **10.** The junction depth and surface concentration of the p-well region **14B** are 1.2-2.0 *µ*m and about 7 × 10¹⁶cm⁻³, respectively.

The junction depth and impurity concentration of both the isolator region **14A** and the p-well region **14B** determine not only device breakdown voltage and component performance of the NMOS transistor **3** but also the device isolation breakdown voltage of the npn bipolar transistor **1**. Therefore, when the junction depth and impurity concentration of both the isolator region **14A** and the n-well region **14B** are insufficient, breakdown voltage between the collector region **12A** and the n-well region **12B** becomes poor.

The LOCOS layers **15A, 15C, 15D,** and **15E** are layers for isolation between devices, are formed in respective device isolation regions of the npn bipolar transistor **1,** the PMOS transistor **2,** and the NMOS transistor **3** by means of selective oxidation, each LOCOS layer having a film thickness in the range of 400 to 800 nanometers. The LOCOS layer **15B** is a layer for isolation between devices, is formed in a base-collector electrode extraction portion region by means of selective oxidation, and has a film thickness in the range of 400 to 800 nanometers.

If the LOCOS layer **15B** is thin, this results in increase in parasitic capacitance between base and collector of the npn bipolar transistor **1**. If the LOCOS layer **15D** is thin, this results in decrease in device isolation breakdown voltage between the PMOS transistor **2** and the NMOS transistor **3.** If the LOCOS layer **15** is thick, a great step is created at end.

The first gate oxide layer **16C** is an insulator layer which has a film thickness of about 10 nanometers and which is formed on a surface portion of the epitaxial layer of the PMOS transistor **2** by means of pyrogenic oxidation. The second gate oxide layer **16D** is an insulator layer which has a film thickness of about 10 nanometers and which is formed on a surface portion of the epitaxial layer of the NMOS transistor 3 by means of pyrogenic oxidation.

The electrode **18A** is formed as follows. A polysilicon layer is deposited having a film thickness in the range of 300 to 400 nanometers so that one end of the electrode **18A** is bound to the graft base region **34** and the other end extends over the LOCOS layer **15B** or **15C.** Subsequently, boron as a p-type impurity material is introduced to such an extent that the sheet resistivity is 100-200 Ω/□ , and an etching step is carried out to form the electrode **18A.**

The electrodes **18C** and **18D** are formed as follows. Polysilicon is deposited having a film thickness in the range of 300 to 400 nanometers. Phosphorus or arsenic as an n-type impurity material is introduced to such an extent that the sheet resistivity is 20-40 Ω/□ . An etching step is carried out to form the electrodes **18C, 18D.**

Each of the insulator layer **19A** on top of the electrode **18A,** the insulator layer **19C** on top of the electrode **18C,** and the insulator layer **19D** on top of the electrode **18D,** is formed as follows. TEOS or the like material is deposited on each electrode **18A, 18C, 18D** having a film thickness in the range of 120 to 250 nanometers, and an etching step is carried out.

In the PMOS transistor **2**, because of a side-wall surface which has a thickness in the range of 100 to 200 nanometers and which is made up of the oxide layer **20C,** the silicon nitride layer **21C,** and the layer **29A,** the source-drain region **30A** is formed in a manner of self-alignment with the electrode **18C.**

The source-drain region **30A** is formed by means of an ion implant step with boron. The junction depth and surface concentration of the region **30A** are about 0.2 *µ*m and about 1 × 10²⁰ cm⁻³, respectively. The LDD region **27A** is formed by means of an ion implant step with boron using the silicon nitride layer **21C** as an implant side-wall. The surface concentration and junction depth of the LDD region **27A** are about 1 × 10¹⁸cm⁻³ and about 0.2 *µ* m, respectively.

In the NMOS transistor **3,** because of a side-wall which has a thickness in the range of 100 to 200 nanometers and which is made up of the oxide layer **20D,** the silicon nitride layer **21D,** and the layer **29B,** the second source-drain region **31A** is formed in a manner of self-alignment with the electrode **18D.**

The source-drain region **31A** is formed by an ion implant step with arsenic. The junction depth and surface concentration of the region **31A** are about 0.1 *µ*m and about 1 × 10²⁰cm⁻³, respectively. The LDD region **28A** is formed by an ion implant step with phosphorus using the silicon nitride layer **21D** as an implant side-wall. The junction depth and surface concentration of the LDD region **28A** are about 0.2 µm and about 1 × 10¹⁸cm⁻³, respectively.

Because of these LDD structures, hot carrier resistance is improved, and by optimizing the thicknesses of the side-wall surfaces **29A** and **29B** to 100-200 nanometers, device characteristics such as hot carrier resistance and the value of saturation drain current become good.

In the npn bipolar transistor **1,** the opening **33** is formed in a manner of self-alignment with a side-wall which has a thickness in the range of 200 to 300 nanometers and which is made up of the oxide layer **20A** having a thickness in the range of 15 to 30 nanometers, the silicon nitride layer **21A** having a thickness of 40 to 80 nanometers, and the polysilicon layer **22A** having a thickness of about 200 nanometers.

Each of the electrodes **25** and **26** is formed as follows. An ion implant with ions of arsenic is carried out to such an extent that the film thickness is 150-300 nanometers and the sheet resistivity is 150-300 Ω/□ .

The graft base region **34** is formed as follows. Boron is introduced through the electrode **18A** and, as a result, the graft base region **34,** the junction depth and surface concentration of which are 0.2-0.4 *µ*m and 1 × 10²⁰cm⁻³ to 3 × 10²⁰cm⁻³, respectively, is formed.

The base region **35** is formed as follows. Boron is introduced and, as a result, the base region **35,** the junction depth and surface concentration of which are 0.15-0.25 *µ*m and 1 × 10¹⁹cm⁻³ to 3 × 10¹⁹cm⁻³, respectively, is formed.

The emitter region **23** is formed as follows. Arsenic is introduced through the electrode **25A,** and, as a result, the region **23,** the junction depth and surface concentration of which are 0.05-0.1 *µ*m and 1 × 10²⁰cm⁻³ to 3 × 10²⁰cm⁻³, respectively, is formed.

The collector contact region **24** is formed as follows. Arsenic is introduced through the electrode **26** and, as a result, the collector contact region **24,** the junction depth and surface concentration of which are 0.05 to 0.1 *µ*m and 1 × 10²⁰cm⁻³ to 3 × 10²⁰cm⁻³, respectively, is formed.

As described above, the oxide layer **20A,** the silicon nitride layer **21A,** and the polysilicon layer **22A** together form the aforesaid side-wall layer. Because of such side-wall layer formation, the opening **33** and the emitter region **23** are formed in a manner of self-alignment with the electrode **18A** and the graft base region **34,** and the oxide layer **20A** and the silicon nitride layer **21A** act as insulator layers for electrical isolation between the electrode **18A** and the emitter extraction electrode **25.**

In accordance with the present embodiment, the electrode **18A** has on its side-surface an insulator layer made up of two thin layers and, as a result, contraction stress by the insulator layer applied to around the perimeter of the emitter-base junction is reduced, whereupon emitter-base leakage becomes controllable. Additionally, the side-surface of the electrode **18A** in contact with the electrode **25** is formed of polysilicon which is a conductor, whereupon the opening **33** comes to have a greater diameter, in other words the aspect ratio of the opening **33** (the ratio of the opening's **33** height to its diameter) decreases. As a result, the emitter resistance of the electrode **25** of polysilicon decreases.

Further, if a layer of polysilicon, which is formed, by the same fabrication step as the layer **22A,** on the side-surface of the electrode **18A** extending towards the LOCOS layer **15B,** is not stripped, this produces the problem that leakage between other conductor layers may occur through such a polysilicon layer or the problem that parasitic capacitance increases, therefore leading to deterioration in the characteristics of the npn bipolar transistor **1.** Such an unstripped polysilicon layer, however, is removed during a fabrication step for forming the insulator side-wall layer **29A**. Accordingly, such a problem can be avoided without increase in the number of fabrication steps.

If the side-wall layer, made up of three layers, of the electrode **18A** is thick, this results in an increase in the base resistance. On the other hand, if such a side-wall layer is thin, this results in an increase in the carrier transit time that has an effect on the heavily-doped graft base region **34.** As described above, the thickness of the side-wall layer as a result of lamination of three layers, which determines FIRST PARAMETER of the bipolar transistor **1**, is optimized to 200-300 nanometers. The thickness of the side-wall layers of the electrodes **18C** and **18D,** which determines SECOND PARAMETER, is optimized to 100-200 nanometers. In other words, the thickness of the bipolar transistor's **1** side-wall layer can be optimized independently of the thickness of the transistors' **2** and **3** side-wall layers, with advantages.

### EMBODIMENT 2

Referring now to the accompanying drawing figures, a second preferred embodiment of this invention is described below.

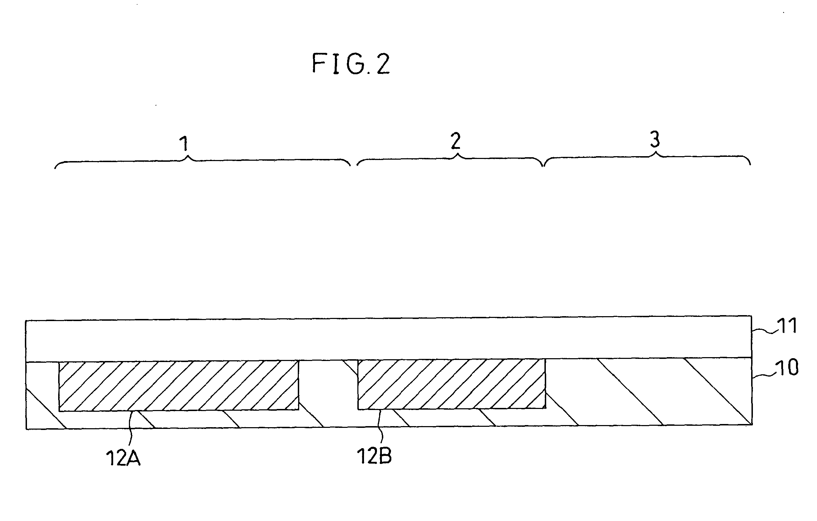

FIGURES **2-7** depict schematic cross-sections of a semiconductor substrate at different stages of the fabrication of an SIC apparatus in accordance with the second embodiment of the present invention. **10** is a p-type semiconductor substrate of silicon. The semiconductor substrate **10** is overlaid with an epitaxial layer of an n-type semiconductor material. **1** is an npn bipolar transistor. **2** is a PMOS transistor. **3** is an NMOS transistor. **12A** is an n-type buried collector region for the npn bipolar transistor **1** and is formed in an upper portion of the silicon substrate **10**. **12B** is an n-type buried well region for the PMOS transistor **2** and is formed in an upper portion of the silicon substrate **10.**

The silicon substrate **10** is a boron-doped, (100)-plane silicon having a resistivity of about 10 Ω·cm. The npn bipolar transistor **1,** the PMOS transistor **2,** and the NMOS transistor **3** are formed over the silicon substrate **10.**

A photolithography step is carried out to pattern a layer of photoresist applied onto the surface of the silicon substrate **10,** to open windows at predetermined locations where the npn bipolar transistor **1** and the PMOS transistor **2** are formed. Ions of arsenic or antimony are implanted through the photoresist pattern serving as a mask against ion implantation to the silicon substrate **10** at a dose and implant energy of about 1 × 10¹⁵cm⁻² and 40-60 KeV, respectively.

The photoresist mask is stripped off the silicon substrate **10** by oxygen-plasma ashing. A thermal annealing step is carried out at a temperature in the range of 1150 to 1200 degrees centigrade for about 15-30 minutes. As a result, the n-collector region **12A** and the n-well region **12B,** the junction depth and sheet resistivity of which are 1-2 µm and 50-150 Ω/□ , respectively, are formed.

An n-type epitaxial layer **11** is deposited on the silicon substrate **10,** having a film thickness in the range of 0.8 to 1.5 µm and a resistivity of 1-5 Ω·cm by impurities such as arsenic and phosphorus. More specifically, the epitaxial layer **11** is deposited at 1050 degrees centigrade at about 80 × 133.322 Pa using a mixture of dichlorsilane and arsine.

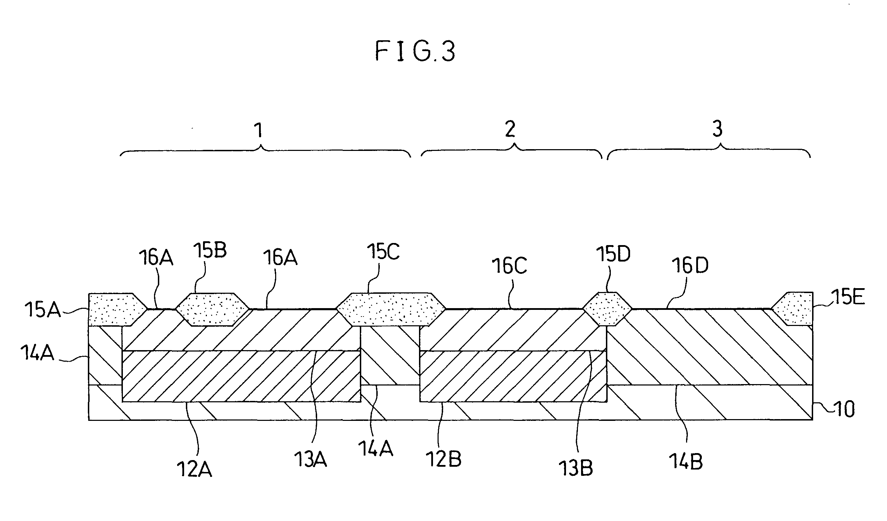

FIGURE **3** is now described. **13A** is an n-type collector region formed at an upper portion of the epitaxial layer **11**. **13B** is an n-type well region formed at an upper portion of the epitaxial layer **11. 14A** is an isolator region for isolation between devices. The isolator region **14A** is formed at an upper portion of the epitaxial layer **11** such that the region **14A** extends to the silicon substrate **10. 14B** is a p-type well region for the NMOS transistor **3.** The p-well region **14B** is formed at an upper portion of the epitaxial layer **11** such that the region **14B** extends to the silicon substrate **10. 15A-15E** are LOCOS layers for providing isolation between devices. **16A** is an insulator layer formed by means of oxidation of a surface portion of the epitaxial layer **11. 16C** is a first gate insulator layer for the PMOS transistor **2** and is formed by means of oxidation of a surface portion of the epitaxial layer **11. 16D** is a second gate insulator layer for the NMOS transistor **3** formed by means of oxidation of a surface portion of the epitaxial layer **11**.

A photolithography step is carried out to pattern a layer of photoresist applied onto the surface of the epitaxial layer **11**, so that windows are opened at predetermined locations where the npn bipolar transistor **1** and the PMOS transistor **2** are formed. Through such a photoresist pattern acting as a mask against ion implantation, an ion implant step with ions of phosphorus is carried out to the epitaxial layer **11** at a dose and implant energy of about 1 × 10¹³cm⁻² and about 100 KeV, respectively.

The photoresist mask is stripped from the silicon substrate **10** by means of oxygen-plasma ashing. A photolithography step is carried out to pattern a layer of photoresist applied, so that windows are opened at predetermined locations where a device isolation region for the npn bipolar transistor **1** and the NMOS transistor 3 are formed. Thorough such a photoresist layer serving as a mask against ion implantation, an ion implant step with ions of boron is carried out at a dose and implant energy of 1 × 10¹³cm⁻² to 2 × 10¹³cm⁻² and about 20 KeV, respectively. The photoresist mask is stripped from the silicon substrate **10** by means of oxygen-plasma ashing, and a thermal annealing step is carried out in an atmosphere of nitrogen at about 1100 degrees centigrade for 90-150 minutes.

As a result of such processing, the n-collector region **13A,** the diffusion depth and surface concentration of which are 0.8-1.5 *µ*m and about 5 × 10¹⁶cm⁻³, respectively, is formed extending to the n-collector region **12A** of the npn bipolar transistor **1.** The n-well region **13B,** the diffusion depth and surface concentration of which are 0.8-1.5 *µ*m and about 5 × 10¹⁶cm⁻³, respectively, is formed extending to the n-well region **12B.** The isolator region **14A,** the diffusion depth and surface concentration of which are 1.2-2.0 *µ*m and about 7 × 10¹⁶cm⁻³, respectively, is formed at the device isolation region extending to the silicon substrate **10**. The p-well region **14B**, the diffusion depth and surface concentration of which are 1.2-2.0 *µ*m and about 7 × 10¹⁶ cm⁻³, respectively, is formed extending to the silicon substrate **10.**

A silicon nitride layer is formed at the surface of the epitaxial layer **11**. This silicon nitride layer acts as a selective mask at the time of forming the LOCOS layers. The silicon nitride layer is deposited by means of an LPCVD step in which a mixture of dichlorsilane and arsine is employed, having a film thickness of about 120 nanometers. Subsequently, a layer of photoresist is applied onto the silicon nitride layer, and a photolithography step is carried out to pattern the photoresist layer for formation of device isolator regions for the transistors **1**, **2**, **3**, and an isolator region for the bipolar transistor's **1** base collector electrode extraction portion. Thereafter, a dry etching step is carried out using a mixture of flon and a gas of the bromine family for selective removal of the silicon nitride layer from over the isolator regions, through the photoresist pattern serving as an etch mask. The photoresist mask is stripped from the silicon substrate **10** by means of oxygen-plasma ashing. Subsequently, a pyrogenic oxidation step is carried out at about 1050 degrees centigrade for about 60 minutes, to form the LOCOS layers **15A-E** each of which has a film thickness in the range of 400 to 800 nanometers.

The silicon nitride layer is removed using a solution of phosphoric acid. Subsequently, a photolithography step is carried out to pattern a layer of photoresist applied, so that a window is opened at a predetermined location where the PMOS transistor **2** is formed. Through such a photoresist pattern acting as a mask against ion implantation, an ion implant with ions of boron is carried out at a dose and implant energy of about 4 × 10¹²cm⁻² and about 20 KeV, respectively, for the purpose of controlling the threshold voltage of the PMOS transistor **2**. The photoresist mask is stripped from the silicon substrate **10** by means of oxygen-plasma ashing. Likewise, a photolithography step is carried out to pattern a layer of photoresist applied, so that a window is opened at a predetermined location where the NMOS transistor **3** is formed. Through such a photoresist pattern serving as a mask against ion implantation, an ion implant with ions of boron is carried out at a dose and implant energy of about 3 × 10¹²cm⁻² and about 40 KeV, respectively, for the purpose of controlling the threshold voltage of the NMOS transistor **3**. As a result of the ion implant steps for control of the threshold voltages, the threshold voltage of the PMOS transistor **2** is held from-0.5 to - 0.8 V and the threshold voltage of the NMOS transistor **3** is held from 0.5 to 0.8 V.

The photoresist mask is stripped from the silicon substrate **10** by means of oxygen-plasma ashing. Subsequently, the entire surface of the epitaxial layer **11** is subjected to a pyrogenic oxidation step at about 900 degrees centigrade for about 30 minutes, whereupon the insulator layer **16A,** the first gate insulator layer **16C,** and the second gate insulator layer **16D,** each of which has a film thickness of about 10 nanometers, are formed.

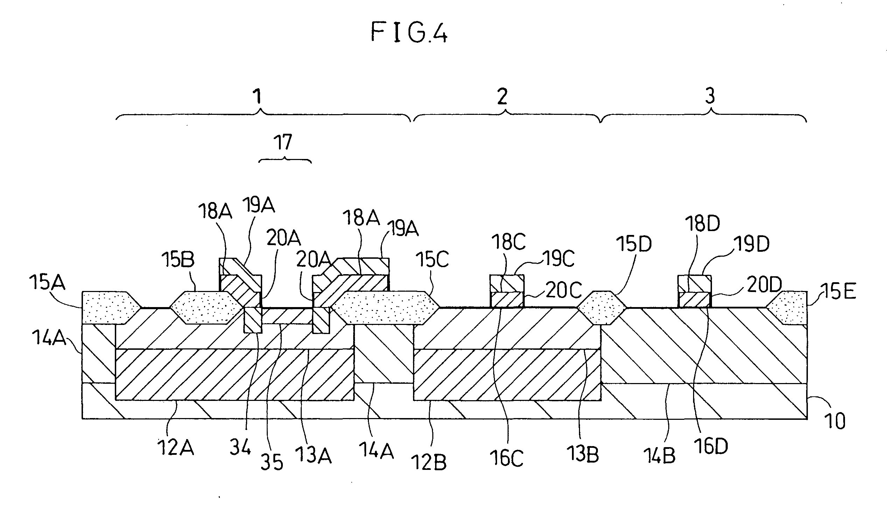

FIGURE **4** is now described. **17** is an emitter-base formation region that is formed in a self-aligned manner. **18A** is a base extraction electrode of polysilicon for the npn bipolar transistor **1. 18C** is a first gate electrode of polysilicon for the PMOS transistor **2. 18D** is a second gate electrode of polysilicon for the NMOS transistor **3. 19A** is a TEOS insulator layer on top of the electrode **18A. 19C** is a TEOS insulator layer on top of the electrode **18C. 19D** is a TEOS insulator layer on top of the electrode **18D. 20A** is an oxide layer formed at a side-surface of the electrode **18A** of the npn bipolar transistor **1** by thermal oxidation. **20C** is an oxide layer formed at a side-surface of the electrode **18C** of the PMOS transistor **2** by thermal oxidation. **20D** is an oxide layer formed at a side-surface of the electrode **18D** of the NMOS transistor **3** by thermal oxidation. **34** is a graft base region for the npn bipolar transistor **1**. **35** is an active base region for the npn bipolar transistor **1**.

An etching step, which uses a photoresist mask produced by photolithography as an etch mask and which uses a mixture of ammonium fluoride and hydrofluoric acid, is carried out to selectively etch away the insulator layer **16A** of the npn bipolar transistor **1.**

The photoresist mask is stripped from the silicon substrate **10** by means of oxygen-plasma ashing. Subsequently, a layer of polysilicon is deposited 300-400 nanometers on the entire surface of the epitaxial layer **11** by an LPCVD step in which a silane gas is used, for formation of the electrodes of the transistors **1-3.** Then, through a predetermined photoresist pattern for the npn bipolar transistor **1** serving as a mask against ion implantation, an ion implant with ions of boron is carried out at a dose in the range of 5 × 10¹⁵cm⁻² to 1 × 10¹⁶cm⁻² at an implant energy of about 40 KeV. Subsequently, an oxygen-plasma ashing step is carried out to strip the photoresist mask. Subsequently, through a predetermined photoresist pattern for the transistors **2** and **3** serving as a mask against ion implantation, an ion implant with ions of phosphorus is carried out at a dose in the range of 1.5 × 10¹⁶cm⁻² to 3 × 10¹⁶cm⁻² at an implant energy of about 40 KeV.

An oxygen-plasma ashing step is carried out to strip the photoresist mask. An LPCVD step, in which a mixture of TEOS and oxygen is employed, is carried out at about 700 degrees centigrade in order to deposit a 120- to 250-nm thick oxide layer on the entire surface of the previously deposited polysilicon layer. Subsequently, by using a predetermined photoresist pattern as a mask against dry etching, the oxide layer deposited is dry etched using a mixture of CHF₃, ammonia, and oxygen. Thereafter, the polysilicon layer deposited is etched anisotropically using a mixture of SF₆, C₂, and ClF₅, to form the electrode **18A** having a sheet resistivity in the range of 100 to 200 Ω/□ , and the electrode **18C** and the electrode **18D** having a sheet resistivity in the range of 20 to 40 Ω/□ . The insulator layers **19A, 19C, 19D** each having a film thickness in the range of 120 to 250 nanometers are formed on the electrodes **18A, 18C, 18D,** respectively, and at the same time the emitter-base formation region **17** for the npn bipolar transistor **1** is opened.

The photoresist mask is removed by means of oxygen-plasma ashing. This is followed by a thermal annealing step at about 900 degrees centigrade for about 30 minutes in an atmosphere of oxygen, whereupon the oxide **20A** layer is formed at the electrode's **18A** side-surface, the oxide layer **20C** is formed at the electrode's **18C** side-surface, and the oxide layer **20D** is formed at the electrode's **18D** side-surface, each oxide layer **20A, 20C, 20D** having a film thickness in the range of 15 to 30 nanometers.

A thermal annealing step is carried out at about 950 degrees centigrade for about 30 minutes in an atmosphere of nitrogen. This annealing step forces the boron impurities contained in the electrode **18A** of the npn bipolar transistor **1** into the n-collector region **13A** and, as a result, the graft base region **34,** the junction depth and surface concentration of which are 0.2-0.4 *µ*m and 1 x 10²⁰cm⁻³ to 3 × 10²⁰cm⁻³, respectively, is formed.

Using a photoresist pattern by a photolithography step and the electrode **18A** as a mask against ion implantation, an ion implant with ions of boron is carried out at a dose and implant energy of about 1 × 10¹³cm⁻² and about 10 KeV, respectively and, as a result, the active base region **35** is formed, having a junction depth in the range of 150 to 250 nanometers and a surface concentration in the range of 1 × 10¹⁹cm⁻³ to 3 × 10¹⁹cm⁻³. This is followed by removal of the photoresist mask by means of oxygen-plasma ashing.

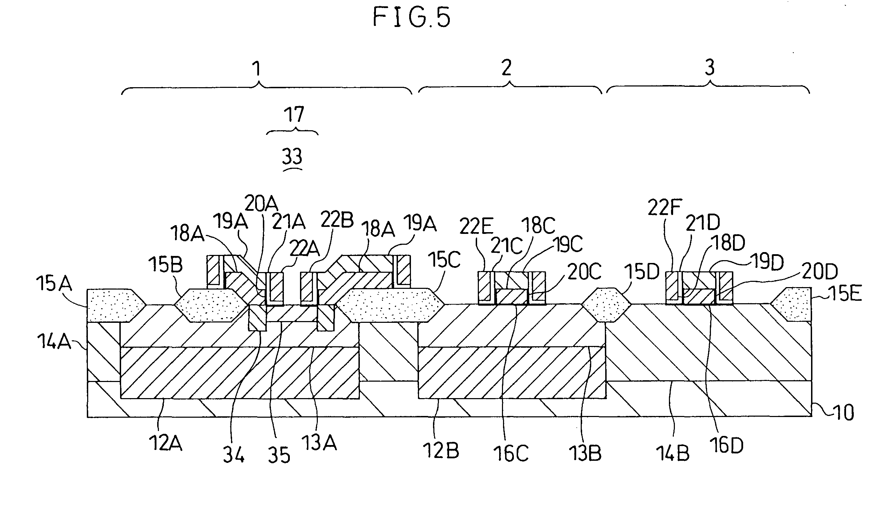

FIGURE **5** is now described. **21A** is a silicon nitride layer over the side-surface of the electrode **18A. 21C** is a silicon nitride layer over the side-surface of the electrode **18C. 21D** is a silicon nitride layer over the side-surface of the electrode **18D. 22A** and **22B** are layers of polysilicon over the side-surfaces of the electrodes **18A, 18A. 22E** is a layer of polysilicon over the side-surface of the electrode **18C. 22F** is a layer of polysilicon over the side-surface of the electrode **18D. 33** is an emitter extraction opening which is formed in a manner of self-alignment with the layers **22A** and **22B.**

A silicon nitride layer is deposited over the entirety of the epitaxial layer **22** by means of an LPCVD step in which a mixture of dichlorsilane and arsine is used in order that insulator layers are formed on the side-surfaces of the electrodes **18A, 18C, 18D,** each insulator layer having a film thickness in the range of 40 to 80 nanometers.

A layer of polysilicon is deposited about 200 nanometers on the silicon nitride layer for formation of side-wall layers for the electrodes **18A, 18C.**

The polysilicon layer deposited is etched anisotropically using a mixture of SF₆ and CCl₄ so as to form the polysilicon layers **22A** and **22B** on the side-surfaces of the electrodes **18A, 18A,** the polysilicon layer **22E** on the side-surface of the electrode **18C,** and the polysilicon layer **22F** on the side-surface of the electrode **18D.**

Using the polysilicon side-wall layers as masks against etching, an etching step is carried out using a mixture of flon and a gas of the bromine family, to form the silicon nitride layer **21A** on the side-surface of the electrode **18A,** the silicon nitride layer **21C** on the side-surface of the electrode **18C,** and the silicon nitride layer **21D** on the side-surface of the electrode **18D.**

An etching step, which uses a mixture of ammonium fluoride and hydrofluoric acid, is carried out to strip the oxide layer from the collector electrode formation region in the npn bipolar transistor **1**, from the opening **33,** and from the source and drain formation regions of the transistors **2, 3.** As a result, a 200-300 nm thick side-wall layer, made up of three different layers (i.e., the oxide layer **20A,** the silicon nitride layer **21A,** and the polysilicon layer **22A),** is formed and, at the same time, the opening **33** is formed in a self-aligned manner.

In accordance with the present embodiment, FIRST PARAMETER is determined by the aforesaid side-wall layer formed of the three layers **20A, 21A, 22A.**

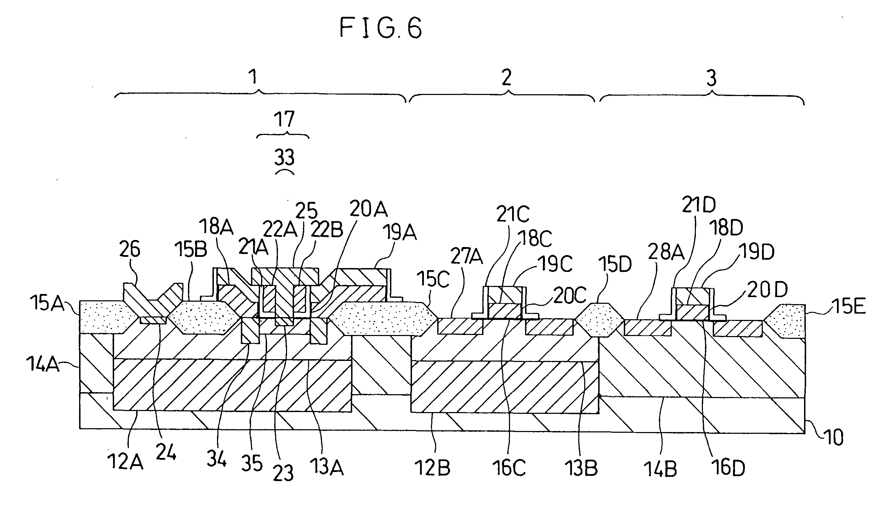

FIGURE **6** is now described. **23** is an emitter region for the npn bipolar transistor **1**. The emitter region **23** is formed in a manner of self-alignment with the layers **22A, 22B** on the side-surfaces of the electrodes **18A, 18A. 24** is a collector contact region for the npn bipolar transistor **1** which is formed by means of thermal annealing. **25** is an emitter extraction electrode for the npn bipolar transistor **1.** This electrode **25** is formed of polysilicon. **26** is a collector extraction electrode for the npn bipolar transistor **1.** This electrode **26** is formed of polysilicon. **27A** is a first LDD region that is formed using the silicon nitride layer **21C** as a side-wall. **28A** is a second LDD region that is formed using the silicon nitride layer **21D** as a side-wall.

A layer of polysilicon is deposited 150-300 nanometers on the entire surface of each device formed on the epitaxial layer **11**, by means of an LPCVD step using a silane gas, for formation of the electrodes **25** and **26**. An ion implant with ions of arsenic is carried out to the deposited polysilicon layer, at a dose and implant energy of about 1 × 10¹⁶cm⁻² and about 60 KeV.

A thermal annealing step is carried out at 900 degrees centigrade for 30-60 minutes in an atmosphere of nitrogen and, as a result, the arsenic impurities contained in the deposited polysilicon layer are diffused into the n-collector region **13A** to form the collector contact region **24** and also into the active base region **35** to form the emitter region **23.** The junction depth and surface concentration of both the collector contact region **24** and the emitter region **23** are 50 to 100 nanometers and 1 × 10²⁰ cm⁻³ to 3 × 10²⁰ cm⁻³, respectively.

Next, using a predetermined photoresist pattern by a photolithography step as a mask against etching, an RF etching step, which uses a mixture of HCl, HBr and oxygen, is carried out to the deposited polysilicon layer at a processing pressure in the range of 100 × 133.322 mPa to 200 × 133.322 mPa, whereupon the electrodes **25** and **26** for the npn bipolar transistor **1** are formed having a sheet resistivity in the range of 150 to 300 Ω/□ .

Another RF etching step is carried out under the same etching parameters as the previous one, so as to strip the layers **22E** and **22F** from the electrodes' **18C, 18D** side-surfaces. Subsequently, the photoresist mask is removed by means of oxygen-plasma ashing.

Using both a photoresist pattern by a photolithography step and the silicon nitride layer **21C** at the side-surface of the electrode **18C** as a mask against ion implantation, an ion implant with ions of boron is carried out at a dose and implant energy of about 5 × 10¹²cm⁻² and about 20 KeV, respectively and, as a result, the LDD region **27A** is formed in a manner of self-alignment with the silicon nitride layer **21C** at the side-surface of the electrode **18C.** The junction depth and surface concentration of the LDD region **27A** are about 0.2 µm and about 1 × 10¹⁸cm⁻³, respectively. Subsequently, an oxygen-plasma ashing step is carried out to remove the photoresist mask.

Next, using both a photoresist pattern produced by a photolithography step and the silicon nitride layer **21D** as a mask against ion implantation, an ion implant with ions of phosphorus is carried out at a dose and implant energy of about 1 × 10¹³cm⁻² and about 40 KeV, respectively. As a result, the LDD region **28A** is formed in a manner of self-alignment with the silicon nitride layer **21D.** The junction depth and surface concentration of the LDD region **28A** are about 0.2 *µ*m and 1 × 10¹⁸cm⁻³, respectively. The photoresist mask is stripped by means of oxygen-plasm ashing.

In accordance with the present embodiment, the electrode **18A** has the side-wall covered with an insulator layer made up of two thin layers and, as a result, contraction stress by the insulator layer applied to around the perimeter of the emitter-base junction is reduced, whereupon leakage between emitter and base becomes controllable. Additionally, the side-surface of the electrode **18A** in contact with the electrode **25** is formed of polysilicon which is a conductor, whereupon the opening **33** comes to have a greater diameter, in other words the aspect ratio of the opening **33** (the ratio of the opening's **33** height to its diameter) decreases. As a result, the emitter resistance of the electrode **25** of polysilicon decreases.

Further, if a polysilicon layer lying over portions of the side-surface of the electrode **18A** which do not belong to the region **17,** is not stripped, this produces the problem that the npn bipolar transistor **1** is likely to have poor characteristics due to leakage between other conductor layers by the polysilicon layer left unstripped or due to increase in the parasitic capacitance. Such an unstripped polysilicon layer, however, is stripped at the same time that the layer **22E** is stripped. Accordingly, such a problem can be avoided without increase in the number of fabrication steps.

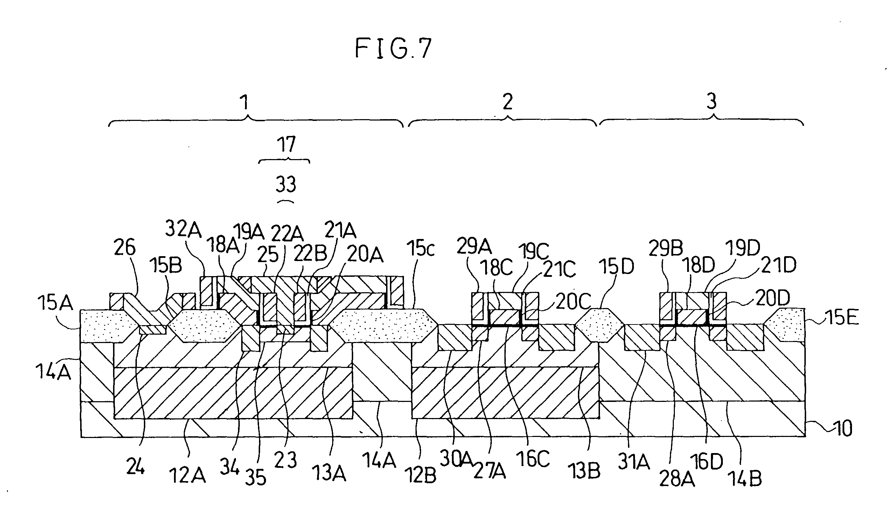

FIGURE 7 is now described. **29A** is a TEOS insulator side-wall layer for the electrode **18C. 29B** is a TEOS insulator side-wall layer for the electrode **18D. 30A** is a first source-drain region formed in a manner of self-alignment with the side-wall layer **29A. 31A** is a second source-drain region formed in a manner of self-alignment with the side-wall layer **29B. 32A** is a TEOS insulator side-wall layer for the electrode **18A.**

Insulator layers for the gate electrode side-walls are formed as follows. An oxide layer is deposited about 150 nanometers over the devices on the epitaxial layer **11** by performing an LPCVD step using a mixture of TEOS and oxygen at about 700 degrees centigrade.

The oxide layer deposited is etched anisotropically using a mixture of oxygen and helium, whereupon the side-wall layers **29A, 29B, 32A** are formed.

As a result, a side-wall, which is made up of the oxide layer **20C,** the silicon nitride layer **21C,** and the insulator side-wall layer **29A,** is formed. Additionally, a side-wall, which is made up of the oxide layer **20D,** the silicon nitride layer **21D,** and the insulator side-wall layer **29B,** is formed.

In accordance with the present embodiment, SECOND PARAMETER of both the transistors **1** and **2** is determined by the above-described side-walls. Therefore, FIRST PARAMETER can be determined and optimized independently of SECOND PARAMETER.

An ion implant with ions of boron, in which a photoresist pattern produced by a photolithography step and the insulator side-wall layer **29A** are used as a mask against ion implantation, is carried out at a dose and implant energy of about 5 × 10¹⁵cm⁻² and about 10 KeV, respectively. As a result, the source-drain region **30A** is formed in a manner of self-alignment with the side-wall layer **29A.** The junction depth and surface concentration of the source-drain region **30A** are about 0.2 *µ*m and 1 × 10²⁰cm⁻³, respectively.

The photoresist mask is stripped by means of oxygen-plasm ashing. Subsequently, an ion implant with ions of arsenic, in which a photoresist pattern produced by a photolithography step and the insulator side-wall layer **29B** are used as a mask against ion implantation, is carried out at a dose and implant energy of about 5 × 10¹⁵ cm⁻² and about 40 KeV, respectively. As a result, the source-drain region **31A** is formed in a manner of self-alignment with the side-wall layer **29B.** The junction depth and surface concentration of the source-drain region **31A** are about 0.1 *µ*m and about 1 × 10²⁰cm⁻³, respectively. The photoresist mask is stripped by means of oxygen-plasma ashing.

## Claims

1. Semiconductor integrated circuit comprising:
(a) a bipolar transistor (1) on a substrate (10) of semiconductor material;
(b) a MOS transistor (2, 3) on said semiconductor substrate (10); said bipolar transistor (1) including:
**(a-1)** a base extraction electrode (18A);
said base extraction electrode (18A) being associated with an extrinsic base region (34) around a base region (35);
said base extraction electrode (18A) being overlaid with a first insulator layer (19A), and having at a first side-surface thereof a first side-wall layer;
**(a-2)** an emitter region (23);
said emitter region (23) being self-aligned with said first side-wall layer;
**(a-3)** an emitter extraction electrode (25);
said MOS transistor (2, 3) including:
**(b-1)** a gate electrode (18C, 18D) being overlaid with a second insulator layer (19C, 19D), and having at a side-surface thereof a second side-wall layer;
**(b-2)** a source-drain region (30A, 31A);
said source-drain region (30A, 31A) being self-aligned with said second side-wall layer;
wherein
said first side-wall layer comprises a laminated structure of a third insulator (21A) on the side-surface of said base extraction electrode (18A) and a conductor layer (22A, 22B) overlying said third insulator layer (21A); and
said second side-wall layer comprises a fourth insulator layer (21C, 21D) that is formed concomitantly with said third insulator layer (21A),
**characterized in that**
said second side-wall layer comprises a fifth insulator layer (29A, 29B) laminated to said fourth insulator layer (21 C, 21 D).

2. Semiconductor integrated circuit according to claim 1
**characterized in that**
said fifth insulator layer (29A, 29B) is a layer of silicon oxide.

3. Semiconductor integrated circuit according to claim 1,
**characterized by**
a region of insulation (15B, 15C) surrounding said extrinsic base region (34),
a third side-wall layer (32A) being additionally formed at an outer side-surface of said base electrode (18A) other than said first side-surface which is overlaid with said first side-wall layer (21A, 22A, 22B), and
said base extraction electrode (18A) partly extending over said region of insulation (15B, 15C).

4. Semiconductor integrated circuit according to claim 1
**characterized in that**
said third insulator layer (21A) comprises a silicon nitride layer (21A) which is formed so as to overlie an oxide layer (20A) formed on the side-surface of said base extraction electrode.

5. Semiconductor integrated circuit according to claim 1
**characterized in that**
said conductor layer (22A, 22B) is a layer of polysilicon.

6. Method of fabricating a semiconductor integrated circuit according to claim 1, said method comprising the steps of:
(a) forming over said semiconductor substrate (10) an isolation region (15A, 15C, 15D, 15E) for insulating said bipolar transistor (1) and said MOS transistor (2, 3), and forming a gate insulator (16A, 16C, 16D) over device regions excluding the region where said isolation region (15A, 15C, 15D, 15E) has already been formed;
(b) performing an etching process step to strip said gate insulator layer (16A) from a region where said bipolar transistor (1) is formed, and depositing a first conductor layer and a first insulator layer over the entirety of said thus processed semiconductor substrate;
(c) subjecting said first conductor layer and said first insulator layer to an etching process step to form a base extraction electrode (18A) for said bipolar transistor (1), a first insulator layer (19A) on top of said base extraction electrode (18A), a gate electrode (18C, 18D) for said MOS transistor (2, 3), and a second insulator layer (19C, 19D) on top of said gate electrode (18C, 18D);
(d) forming a further insulator layer (20A, 20C, 20D) on a side-surface of said base extraction electrode (18A), on top of an emitter formation region (35) surrounded by said base extraction electrode (18A), and on a side-surface of said gate electrode (18C, 18D), and depositing on the entirety of said thus processed semiconductor substrate another insulator layer and a second conductor layer;
(e) subjecting said second conductor layer to an etching process step to form a conductor (22A, 22B, 22E, 22F) present only on the side-surface of said base extraction electrode (18A) and on the side-surface of said gate electrode (18C, 18D), to partially form a first side-wall layer;
(f) performing an etching step using said conductor (22A, 22B, 22E, 22F) as an etch mask to remove parts of said further insulator layer and parts of said another insulator layer, thereby to form said first side-wall layer which comprises a patterned portion of said further insulator layer (20A), a third insulator layer (21A) being a patterned portion of said another insulating layer and said second conductor layer (22A, 22B) with an opening (33) for an emitter extraction electrode (25), and to prepare for formation of a second side-wall layer which is to comprise a further patterned portion of said further insulator layer (20C, 20D) and a fourth insulator layer (21C, 21D), being a further patterned portion of said another insulating layer
(g) depositing a third conductor layer (25) on the entirety of said thus processed semiconductor substrate, selectively-etching said third conductor layer (25) to form above said opening (33) said emitter extraction electrode (25), performing a thermal annealing step to form an emitter region (23) in a self-aligned manner below an emitter extraction electrode (25), and performing an etching process step to remove said conductor layer (22E, 22F) of said first side-wall layer from other side-surfaces of said base extraction electrode (18A) except the side-surface thereof covered with said emitter extraction electrode (25), and from the side-surface of said gate electrode (18C, 18D), to expose said fourth insulator layer to form a second side-wall layer;
(h) forming a fifth insulator layer (29A, 32A, 29B) on said fourth insulator layer (21C, 21D) by deposition and etching to form on the side surface of said gate electrode said second sidewall layer
(i) forming said source-drain formation region (30A, 31A) in a manner of self-alignment with said second side-wall layer (21C, 21D).

## Patentansprüche

1. Integrierte Halbleiterschaltung mit:
(a) einem bipolaren Transistor (1) auf einem Substrat (10) aus Halbleitermaterial;
(b) einem MOS-Transistor (2,3) auf dem Halbleitersubstrat (10);
wobei der bipolare Transistor (1) einschließt:
(a-1) eine Basisextraktionselektrode (18A); die
- mit einem extrinsischen Basisbereich (34) verbunden ist, der um eine Basisregion (35) herum angeordnet ist;
- mit einer ersten Isolatorschicht (19A) überlagert ist und
- an einer ersten seitlichen Oberfläche hiervon eine erste Seitenwandschicht hat;
(a-2) einen Emitterbereich (23);
der mit der ersten Seitenwandschicht selbstausgerichtet ist; und
(a-3) eine Emitterextraktionselektrode (25);
und wobei der MOS-Transistor (2,3) einschließt:
(b-1) eine Gate-Elektrode (18C,18D), die mit einer zweiten Isolatorschicht (19C,19D) überlagert ist und die an einer seitlichen Oberfläche hiervon eine zweite Seitenwandschicht hat;
(b-2) einen Source-Drain-Bereich (30A,31A); der mit der zweiten Seitenwandschicht selbstausgerichtet ist;
wobei
die erste Seitenwandschicht eine verbundene Struktur aus einem dritten Isolator (21A) auf der seitlichen Oberfläche von der Basisextraktionselektrode (18A) und einer Leiterschicht (22A,22B), die den dritten Isolator (21A) überlagert, umfasst; und
die zweite Seitenwandschicht eine vierte Isolatorschicht (21C,21D), die gleichzeitig mit der dritten Isolatorschicht (21A) gebildet ist, umfasst,
**dadurch gekennzeichnet, dass**
die zweite Seitenwandschicht eine fünfte Isolatorschicht (29A,298) umfasst, die mit der vierten Isolatorschicht (21C,21D) verbunden ist.

2. Integrierte Halbleiterschaltung gemäß Anspruch 1,
**dadurch gekennzeichnet, dass**
die fünfte Isolatorschicht (29A,29B) eine Schicht aus Siliciumoxid ist.

3. Integrierte Halbleiterschaltung gemäß Anspruch 1,
**gekennzeichnet durch**
einen Isolationsbereich (15B,15C) der den extrinsischen Basisbereich (34) umgibt,
eine dritte Seitenwandschicht (32A), die zusätzlich an einer äußeren seitlichen Oberfläche von der Basiselektrode (18A) verschieden von der ersten seitlichen Oberfläche, die mit der ersten Seitenwandschicht (21A,22A,22B) überlagert ist, gebildet ist und
**dadurch**, dass sich die Basisextraktionselektrode (18A) teilweise über den Isolationsbereich (15B,15C) erstreckt.

4. Integrierte Halbleiterschaltung gemäß Anspruch 1
**gekennzeichnet dadurch,** dass
die dritte Isolationsschicht (21A) eine Siliciumnitridschicht (21A) umfasst, die so gebildet ist, dass sie eine Oxidschicht (20A), die an einer seitlichen Oberfläche der Basisextraktionselektrode gebildet ist, überlagert.

5. Integrierte Halbleiterschaltung gemäß Anspruch 1
**dadurch gekennzeichnet, dass**
die Leiterschicht (22A,22B) eine Schicht aus Polysilicium ist.

6. Verfahren zur Herstellung einer integrierten Halbleiterschaltung gemäß Anspruch 1 wobei das Verfahren die Schritte umfasst:
(a) Bilden eines Isolationsbereichs (15A,15C,15D,15E) über dem Halbleitersubstrat (10) um den bipolaren Transistor (1) und den MOS-Transistor (2,3) zu isolieren und Bilden eines Gate-lsolators (16A,16C,16D) über Elementbereichen, die die Bereiche ausschließen, wo der Isolationsbereich (15A,15C,15D,15E) bereits gebildet wurde;
(b) Ausführen eines Ätzprozessschrittes, um die Gate-lsolatorschicht (16A) von einem Bereich, wo der bipolarer Transistor 1 gebildet wird, zu entfernen und Abscheiden einer ersten Leiterschicht und einer ersten Isolatorschicht über der Gesamtheit von dem so behandeltem Halbleitersubstrat;
(c) den Schritt, die erste Leiterschicht und die erste Isolatorschicht einem Ätzprozessschritt zu unterziehen, um eine Basisextraktionselektrode (18A) für den bipolaren Transistor (1), eine erste Isolatorschicht (19A) auf der Oberseite von der Basisextraktionselektrode (18A), eine Gate-Elektrode (18C,18D) für den MOS-Transistor (2,3) und eine zweite Isolatorschicht (19C,19D) auf der Oberseite von der Gate-Elektrode (18C,18D) zu bilden;
(d) Bilden einer weiteren Isolatorschicht (20A,20C,20D) auf
- einer seitlichen Oberfläche von der Basisextraktionselektrode (18A) auf der Oberseite eines Emitter-Bildungsbereichs (35), die von der Basisextraktionselektrode (18A) umgeben ist und
- auf einer seitlichen Oberfläche von der Gate-Elektrode (18C,18d)
und Abscheiden einer anderen Isolatorschicht und einer zweiten Leiterschicht auf der Gesamtheit von dem so behandeltem Halbleitersubstrat;
(e) den Schritt, die zweite Leiterschicht einem Ätzprozessschritt zu unterziehen, um einen Leiter (22A,22B,22E,22F) zu bilden, der nur an den seitlichen Oberflächen von der Basisextraktionselektrode (18A) und an der seitlichen Oberfläche von der Gate-Elektrode (18C,18D) vorhanden ist, um teilweise eine erste Seitenwandschicht zu bilden;
(f) Durchführen eines Ätzschritts, wobei der Leiter (22A,22B,22E,22F) als Ätzmaske benutzt wird, um Teile von der weiteren Isolatorschicht und Teile von der anderer Isolatorschicht zu entfernen,
um dabei die erste Seitenwandschicht zu bilden, die strukturierte Teile von der weiteren Isolationsschicht (20A), eine dritte Isolatorschicht (21A), die ein strukturierter Teil von der anderen Isolationsschicht ist, und die zweite Leiterschicht (22A,22B) mit einer Öffnung (30) für eine Emitterextraktionselektrode (25) umfasst und
um die Bildung einer zweiten Seitenwandschicht vorzubereiten, die einen weiteren strukturierten Teil von der weiteren Isolatorschicht (20C,20D) und eine vierte Isolatorschicht (21C,21D), die ein weiterer strukturierter Teil von der anderen Isolationsschicht ist, umfassen soll;
(g) Abscheiden einer dritten Leiterschicht (25) auf der Gesamtheit von dem so behandeltem Halbleitersubstrat, selektives Ätzen von der dritten Leiterschicht (25) um über der Öffnung (30) die Emitterextraktionselektrode (25) zu bilden, Ausführen eines thermischen Temperschritts, um einen Emitterbereich (23) in selbstausgerichteter Weise unterhalb der Emitterextraktionselektrode (25) zu bilden und Ausführen eines Ätzprozessschritts, um die Leiterschicht (22E,22F) der ersten Seitenwandschicht von
- anderen seitlichen Oberflächen der Basisextraktionselektrode (18A) mit Ausnahme der seitlichen Oberfläche davon, die mit der Emitterextraktionselektrode (25) bedeckt ist, und
- von der seitlichen Oberfläche von der Gate-Elektrode (18C,18d) zu entfernen,
um die vierte Isolatorschicht freizulegen, um eine zweite Seitenwandschicht zu bilden;
(h) Bilden einer fünften Isolatorschicht (29A,32A,29B) auf der vierten Isolatorschicht (21C,21D) durch Abscheiden und Ätzen, um auf der seitlichen Oberfläche von der Gate-Elektrode die zweite Seitenwandschicht zu bilden
(i) Bilden von dem Source-Drain-Bildungsbereich (30A,31A) in einer Weise der Selbstausrichtung mit der zweiten Seitenwandschicht (21C,21D).

## Revendications

1. Circuit intégré semi-conducteur comprenant :
(a) un transistor bipolaire (1) sur un substrat (10) de matériau semi-conducteur ;
(b) un transistor MOS (2, 3) sur ledit substrat semi-conducteur (10) ;
ledit transistor bipolaire (1) comprenant :
(a-1) une électrode d'extraction de base (18A) ;
ladite électrode d'extraction de base (18A) étant associée à une région de base extrinsèque (34) autour d'une région de base (35) ;
ladite électrode d'extraction de base (18A) étant recouverte d'une première couche isolante (19A) et comportant sur une première surface latérale de celle-ci une première couche de la paroi latérale ;
(a-2) une région émetteur (23) ;
ladite région émetteur (23) étant auto-alignée sur ladite première couche de la paroi latérale ;
(a-3) une électrode d'extraction de l'émetteur (25) ;
le dit transistor MOS (2, 3) comprenant :
(b-1) une électrode de grille (18C, 18D) recouverte d'une deuxième couche isolante (19C, 19D) et comportant sur une surface latérale de celle-ci une deuxième couche de la paroi latérale ;
(b-2) une région source-drain (30A, 31A) ;
ladite région source-drain (30A, 31A) étant auto-alignée sur ladite deuxième couche de la paroi latérale ;
dans laquelle
ladite première couche de paroi latérale comprend une structure stratifiée d'un troisième isolant (21A) sur la surface latérale de ladite électrode d'extraction de base (18A) et une couche conductrice (22A, 22B) recouvrant ladite troisième couche isolante (21A) ; et
ladite deuxième couche de paroi latérale comprend une quatrième couche isolante (21C, 21D) constituée de manière concomitante de ladite troisième couche isolante (21A),
**caractérisé en ce que**
ladite deuxième couche de la paroi latérale comprend une cinquième couche isolante (29A, 29B) stratifiée pour ladite quatrième couche isolante (21C, 21D).

2. Circuit intégré semi-conducteur selon la revendication 1,
**caractérisé en ce que**
ladite cinquième couche isolante (29A, 29B) est une couche d'oxyde de silicium.

3. Circuit intégré semi-conducteur selon la revendication 1,
**caractérisé par**
une région d'isolation (15B, 15C) entourant ladite région de base extrinsèque (34),
une troisième couche de la paroi latérale (32A) étant ajoutée au niveau d'une surface latérale extérieure de ladite électrode de base (18A) autre que ladite première surface latérale qui se superpose à ladite première couche de la paroi latérale (21A, 22A, 22B), et
ladite électrode d'extraction de base (18A) s'étendant partiellement sur ladite région d'isolation (15B, 15C).

4. Circuit intégré semi-conducteur selon la revendication 1,
**caractérisé en ce que**
ladite troisième couche isolante (21A) comporte une couche de nitrure de silicium (21A) qui formée de sorte qu'elle se superpose à une couche d'oxyde (20A) formée sur la surface latérale de ladite électrode d'extraction de base.

5. Circuit intégré semi-conducteur selon la revendication 1,
**caractérisé en ce que**
ladite couche isolante (22A, 22B) est une couche de polysilicium.

6. Procédé de fabrication d'un circuit intégré semi-conducteur selon la revendication 1, ledit procédé comprenant les étapes consistant à :
(a) former sur un substrat semi-conducteur (10) une région d'isolation (15A, 15C, 15D, 15E) pour isoler le dit transistor bipolaire (1) et ledit transistor MOS (2, 3) et former un isolant de grille (16A, 16C, 16D) sur les régions du dispositif à l'exception de la région dans laquelle ladite région d'isolation (15A, 15C, 15D, 15E) a déjà été formée ;
(b) réaliser une étape d'un processus de gravure pour décaper ladite couche isolante de grille (16A) d'une région dans laquelle ledit transistor bipolaire (1) est formé, et déposer une première couche conductrice et une première couche isolante sur la totalité dudit substrat semi-conducteur ainsi traité ;
(c) soumettre ladite première couche conductrice et ladite première couche isolante à une étape d'un processus de gravure pour former une électrode d'extraction de base (18A) pour ledit transistor bipolaire (1), une première couche isolante (19A) au-dessus de ladite électrode d'extraction de base (18A), une électrode de grille (18C, 18D) pour ledit transistor MOS (2, 3) et une deuxième couche isolante (19C, 19D) au-dessus de ladite électrode de la grille (18C, 18D);
(d) former une autre couche isolante (20A, 20C, 20D) sur une surface latérale de ladite électrode d'extraction de base (18A), au-dessus d'une région de formation de l'émetteur (35) entourée par ladite électrode d'extraction de base (18A) et sur une surface latérale de ladite électrode de grille (18C, 18D), et déposer une autre couche isolante et une deuxième couche conductrice sur la totalité dudit substrat semi-conducteur ainsi traité ;
(e) soumettre ladite deuxième couche conductrice à une étape d'un processus de gravure pour former un conducteur (22A, 22B, 22E, 22F) présent uniquement sur la surface latérale de ladite électrode d'extraction de base (18A) et sur la surface latérale de ladite électrode de grille (18C, 18D), pour former partiellement une première couche de paroi latérale ;
(f) réaliser une étape de gravure en utilisant ledit conducteur (22A, 22B, 22E, 22F) comme masque de gravure pour retirer les parties de ladite autre couche isolante et les parties de ladite encore autre couche isolante, ce qui a pour effet de former ladite première couche de paroi latérale qui comprend une partie à motifs de ladite autre couche isolante (20A), une troisième couche isolante (21A) étant une partie à motifs de ladite autre couche isolante et de ladite deuxième couche conductrice (22A, 22B) avec une ouverture (33) pour une électrode d'extraction de l'émetteur (25) et de préparer la formation d'une deuxième couche de paroi latérale qui devra comprendre une autre partie à motifs de ladite autre couche isolante (20C, 20D) et une quatrième couche isolante (21C, 21D) étant une autre partie à motifs de ladite autre couche isolante ;
(g) déposer une troisième couche conductrice (25) sur la totalité dudit substrat semi-conducteur ainsi traité, graver sélectivement ladite troisième couche conductrice (25) pour former ladite ouverture (33) pour ladite électrode d'extraction de l'émetteur (25), réaliser une étape de recuit thermique pour former une région de l'émetteur (23) auto-alignée sous une électrode d'extraction de l'émetteur (25) et réaliser une étape de processus de gravure pour retirer ladite couche conductrice (22E, 22F) de ladite première couche de paroi latérale des autres surfaces latérales de ladite électrode d'extraction de base (18A) à l'exception de la surface latérale de celle-ci couverte par ladite électrode d'extraction de l'émetteur (25) et de la surface latérale de ladite électrode de grille (18C, 18D) pour exposer ladite quatrième couche isolante pour former une deuxième couche de paroi latérale ;
(h) former une cinquième couche isolante (29A, 32A, 29B) sur ladite quatrième couche isolante (21C, 21D) par dépôt et gravure pour former sur la surface latérale de ladite électrode de grille ladite deuxième couche de paroi latérale
(i) former ladite région de formation source-drain (30A, 31A) auto-alignée sur ladite deuxième couche de paroi latérale (21C, 21D) ;
